# EUROPEAN PATENT APPLICATION

(11) **EP 2 280 595 A2**
(43) Date of publication of application: **02.02.2011**
(21) Application number: 10251347.0
(22) Date of filing: 29.07.2010
(51) Int. Cl.: H05K 5/06

(54) **Water tight submersible enclosure**

(30) Priority: 31.07.2009 GB 0913327
(71) Applicant: Valeport Limited, Totnes Devon TQ9 5EW (GB)
(72) Inventor: Goss, Peter, Devon, TQ6 9HR (GB); Quartley, Charles, Devon, TQ12 5UF (GB); Quartley, Matthew, Devon, TQ12 5LH (GB); Nicholson, Julian, Devon, TQ12 5US (GB)
(74) Representative: Leppard, Andrew John

(57) **Abstract**

A watertight submersible enclosure is disclosed. The water tight submersible enclosure (10; 60) for sealingly enclosing electrical/electronic apparatus or the like has at least one opening (70; 72) for access to the interior or a respective internal compartment (18; 20 74; 76) of the enclosure and at least one respective closure member (14; 16; 64; 66; 68) for closing the said opening, wherein a bore seal (40, 42, 24; 82, 84, 86) is provided at the said opening to seal the said opening against the effects of submersion of the enclosure in water or other liquid when the said respective closure member is attached to close the said opening and wherein at least one location means is provided at the said opening for positively locating the respective closure member on the said opening and the said location means comprises at least one upstanding element on one of the enclosure body or the closure member and a corresponding recess for receiving the said upstanding element on the other. With this type of sealing arrangement it is possible to achieve a watertight seal which provides protection against the effects of submersion of the enclosure in water or other liquids.

## Description

### FIELD OF THE INVENTION

The present invention relates to a watertight submersible enclosure and in particular concerns such an enclosure for sealingly enclosing electrical and/or electronic equipment or the like against the effects of submersion.

### BACKGROUND

Enclosures for electrical equipment can be classified according to an international classification system (EN60529) for the sealing effectiveness of enclosures against the intrusion into the electrical apparatus of foreign bodies such as tools, dust, fingers etc. and moisture. The classification system utilises the letters IP (Ingress Protection) followed by 2 or 3 digits. The first digit of the IP code indicates the degree of protection provided for individuals against contact with moving parts (other than smooth rotating shafts, etc.) and the degree that the equipment is protected against the intrusion of solid foreign bodies into the enclosure. Zero represents the situation where the enclosure provides no special protection whereas 6 indicates that the enclosure is dust tight with the digits 1 to 5 representing intermediate conditions therebetween.

The second digit indicates the degree of protection the enclosure provides for the enclosed electrical apparatus against the ingress of moisture into the enclosure. Zero indicates that the enclosure provides no special protection, 1 indicates protection from dripping water, 2 indicates protection from vertically dripping water, 3 indicates protection from sprayed water, 4 indicates protection from splashed water, 5 indicates protection from water projected from a nozzle, 6 indicates protection against heavy seas, or powerful jets of water, 7 indicates protection against immersion, and 8 indicates protection against complete and continuous submersion in water. These numbers are generally associated with a corresponding symbol which symbol are generally provided on the outer surface of an enclosure to indicate the IP protection provided by the enclosure.

Enclosures for electrical apparatus are generally available up to IP67 but not IP68. The requirement for protection against complete continuous submersion in water (IP68) is much more onerous than the requirement for an enclosure that can provide protection against immersion.

Face seals are generally provided between the closure and a corresponding opening in a high performance enclosure, having say a classification of IP67, to provide an immersion resistant seal to prevent the ingress of moisture into the interior of the enclosure on immersion of the enclosure in water or other liquid. Hitherto manufacturers have been reluctant to classify electrical enclosures as IP68 because of the significantly higher performance requirements of an enclosure which is capable of remaining watertight on submersion.

There is a requirement therefore for an enclosure for electrical/electronic apparatus which has a higher performance (moisture resistant) rating than hitherto known IP67 rated enclosures utilising face seals and the like.

### SUMMARY

According to an aspect of the present invention there is provided a water tight submersible enclosure for sealingly enclosing electrical/electronic apparatus or the like, said enclosure having at least one opening for access to the interior or a respective internal compartment of the enclosure and at least one respective closure member for closing the said opening, wherein a bore seal is provided at the said opening to seal the said opening against the effects of submersion of the enclosure in water or other liquid when the said respective closure member is attached to close the said opening and wherein at least one location means is provided at the said opening for positively locating the respective closure member on the said opening and the said location means comprises at least one upstanding element on one of the enclosure body or the closure member and a corresponding recess for receiving the said upstanding element on the other. The present inventors have found that significant improvements to sealing can be realised by using a bore seal type arrangement at the opening to be sealed by a respective closure member. With this type of sealing arrangement it is possible to achieve a watertight seal which provides protection against the effects of submersion of the enclosure in water or other liquids. This type of sealing arrangement is therefore particularly suitable for applications in marine environments, for example, sealing electrical equipment that may, for example, be secured to a harbour wall or other maritime structure or vessel. In preferred embodiments the enclosure of the above aspect of the present invention the at least one location means is provided at or in the region of the opening or openings for positively locating the respective closure member on the opening. The above aspect of the present invention also contemplates embodiments where corresponding protrusion and grooves or overlapping lips are provided between the parts of the enclosure at the seated opening to reduce distortion of the enclosure body when subject to differential pressure acting on the enclosure in use or to reduce the distortion during manufacture if the enclosure is moulded. This is significantly important for relatively long straight or nearly straight parts which are moulded. The location means, which in embodiments may also be used for reducing the effects of distortion as hereinbefore described, comprises at least one upstanding element on one of the enclosure bodies or the closure member and a corresponding recess for receiving the upstanding element on the other.

In a preferred embodiment the bore seal comprises a pair of mating elements, with one of the elements being provided on the closure member and the other around the periphery of the opening such that the elements are bought together when the closure member is attached to close the opening.

The mating elements may comprise a female element and a male element with the bore seal further comprising a resilient seal element positioned between the male and female elements when the male and female elements are brought together to seal the opening. In this way sealing of the enclosure is further enhanced by the provision of the resilient seal element.

In the preferred embodiment the female element of the bore seal is provided by, or in the opening of the enclosure and the male element is provided as an upstanding protrusion on the closure member adapted to fit in the opening. This arrangement is particularly advantageous since it enables the resilient seal element to be accommodated in a recess provided either in the upstanding protrusion of the male element or around the periphery of the opening to be sealed as defined by the female element of the bore seal.

In a preferred embodiment the female element comprises a stepped recess at the opening, with the stepped recess being dimensioned to receive the male element.

The resilient seal element preferably comprises a seal element of an elastomeric material. The seal element is preferably a loop of elastomeric material dimensioned to fit between the male and female elements of the bore seal. The seal element may be rubber or a synthetic elastomeric.

In preferred embodiments the interior of the enclosure is divided to provide at least two internal compartments each having a respective opening and closure member. Thus the above aspect of the invention contemplates embodiments in which the enclosure is provided with a plurality of internal compartments, each of which is provided with a watertight bore seal. This may be important in applications where there is a requirement say to access electrical or electronic equipment in one of the compartments on a more regular basis than electrical or electronic apparatus in another compartment or compartments.

In embodiments where more than one internal compartment is provided respective adjacent closure members may be provided with respective overlapping parts which extend along a common adjoining edge such that one of the overlapping parts may be clamped by the other against the body of the enclosure when the adjacent closure members are secured to the body of the enclosure to close the respective openings of the adjacent internal compartments. In this way it is possible to reduce the number of fasteners such as fixing screws or the like to secure the respective closure members to the body of the enclosure.

One of the internal compartments may be adapted to accommodate a power source such as a battery or the like for providing power, via an electrical connection, to electrical/electronic apparatus sealingly enclosed in one or more other internal compartments in the enclosure. In this way it is possible to locate a battery in one compartment and electrical apparatus in another such that the seal to the compartment enclosing the electrical/electronic apparatus does not have to be disturbed whenever it is necessary to replace the battery in another compartment of the enclosure.

In preferred embodiments electrical terminal means are provided in a dividing wall between respective adjacent compartments for electrically connecting electrical/electronic apparatus and/or electrical power source means accommodated in adjacent compartments. In this way it is possible to electrically connect different apparatus located in different internal compartments within the enclosure.

Preferably fixing means are provided for fixing a closure member to the body of the enclosure to close the respective opening. In preferred embodiments the fixing means comprise fasteners such as screws or the like which are capable of being tightened sufficiently to provide the watertight seal between the two parts of the enclosure.

In preferred embodiments the enclosure comprises a pair of adjacent internal compartments, the respective openings of which are arranged either in a side-by-side relation on one side of the enclosure body or arranged at respective opposite ends of the enclosure. The above aspect of the invention therefore contemplates embodiments which are suitably adapted for different applications which may have different design considerations.

According to another aspect, there is provided a water tight submersible enclosure for sealingly enclosing electrical/electronic apparatus or the like, said enclosure having at least one opening for access to the interior or a respective internal compartment of the enclosure and at least one respective closure member for closing the said opening, wherein a bore seal is provided at the said opening to seal the said opening against the effects of submersion of the enclosure in water or other liquid when the said respective closure member is attached to close the said opening.

In preferred embodiments the enclosure of the above aspect of the present invention the at least one location means is provided at or in the region of the opening or openings for positively locating the respective closure member on the opening. The above aspect of the present invention also contemplates embodiments where corresponding protrusion and grooves or overlapping lips are provided between the parts of the enclosure at the sealed opening to reduce distortion of the enclosure body when subject to differential pressure acting on the enclosure in use or to reduce the distortion during manufacture if the enclosure is moulded. This is significantly important for relatively long straight or nearly straight parts which are moulded.

In preferred embodiments, the location means, which may also be used for reducing the effects of distortion as hereinbefore described, may comprise at least one upstanding element on one of the enclosure bodies or the closure member and a corresponding recess for receiving the upstanding element on the other.

### BRIEF DESCRIPTION OF THE DRAWINGS

Embodiments of the present will now be more particularly described, by way of example only, with reference to the accompanying drawings, in which:
Figure 1 is a perspective view of an enclosure according to a first embodiment of the present invention with the closure members removed from the main body of the closure;
Figure 2 is a perspective view of the main body of enclosure shown in Figure 1;
Figure 3 is a detailed perspective view of the left hand closure member shown in Figure;
Figure 4 is a perspective view of the enclosure of Figure 1 with one of the closure members attached to the main body;
Figure 5 is a perspective view of the enclosure of Figure 1, similar to that of Figure 4 but with the second enclosure member shown positioned for attachment;
Figure 6 is a perspective view of the assembled enclosure of Figures 1 to 5;
Figure 7 is a perspective view of the four main components of an enclosure according to a second embodiment of the present invention;

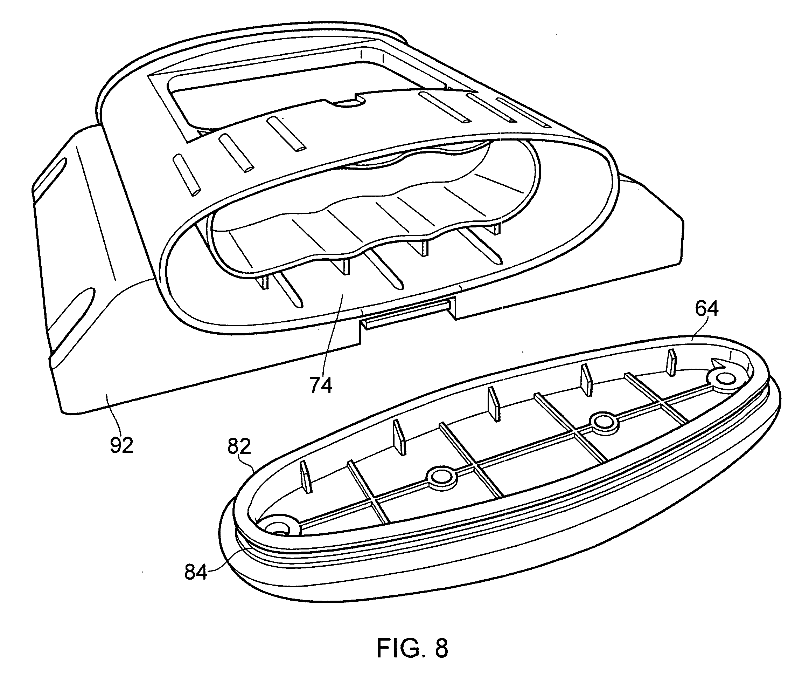

Figure 8 is a perspective view of the enclosure of Figure 1 from one end of the enclosure;

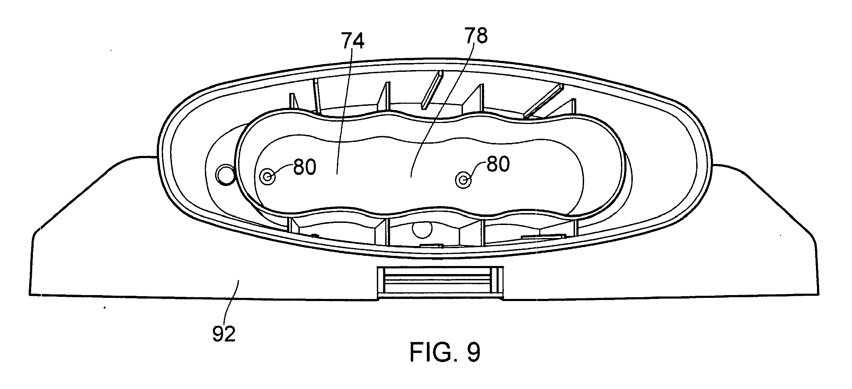

Figure 9 is an end view of the main body of the enclosure at the end shown in Figure 8;

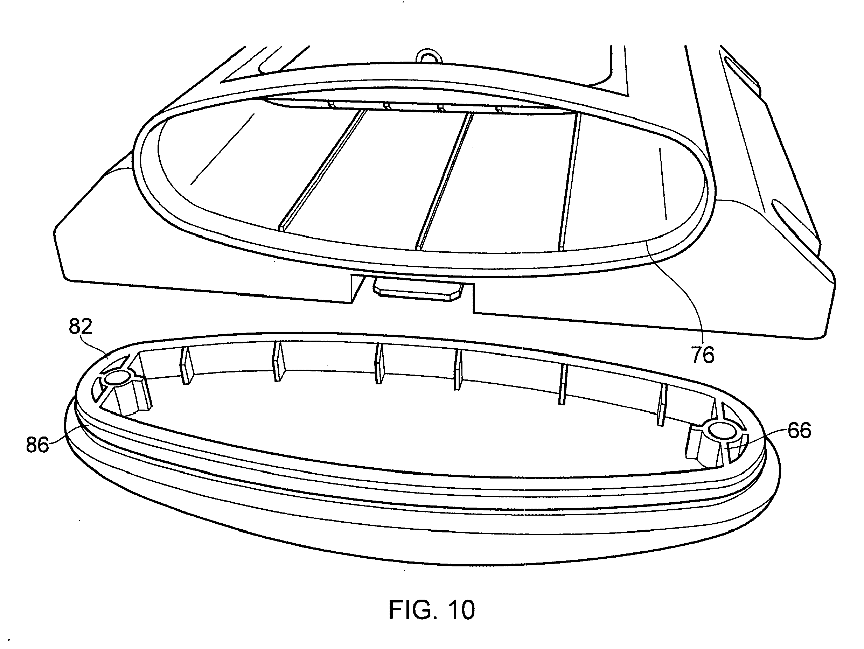

Figure 10 is a perspective view similar to Figure 8 at the other end of the enclosure;

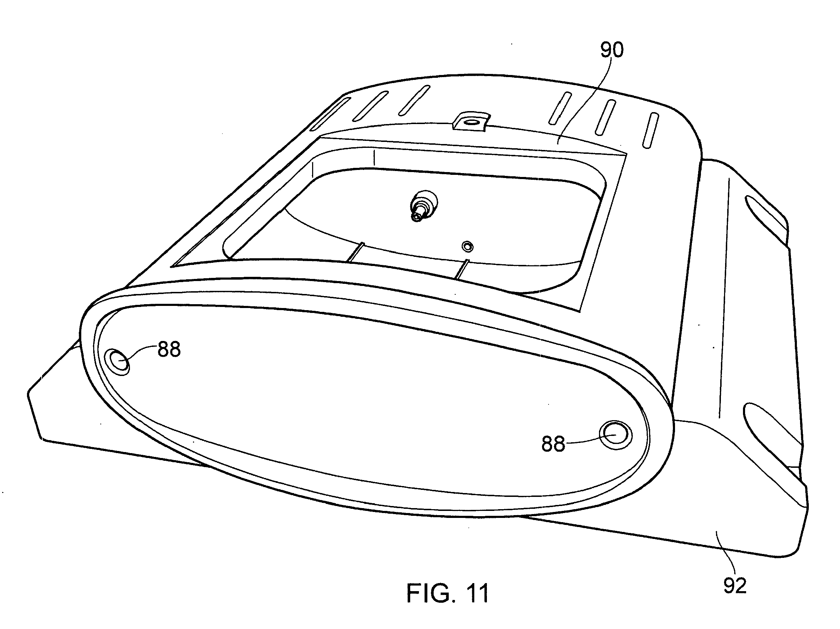

Figure 11 is a perspective view of the enclosure similar to that of Figure 10 but with the closure member attached to the opening;

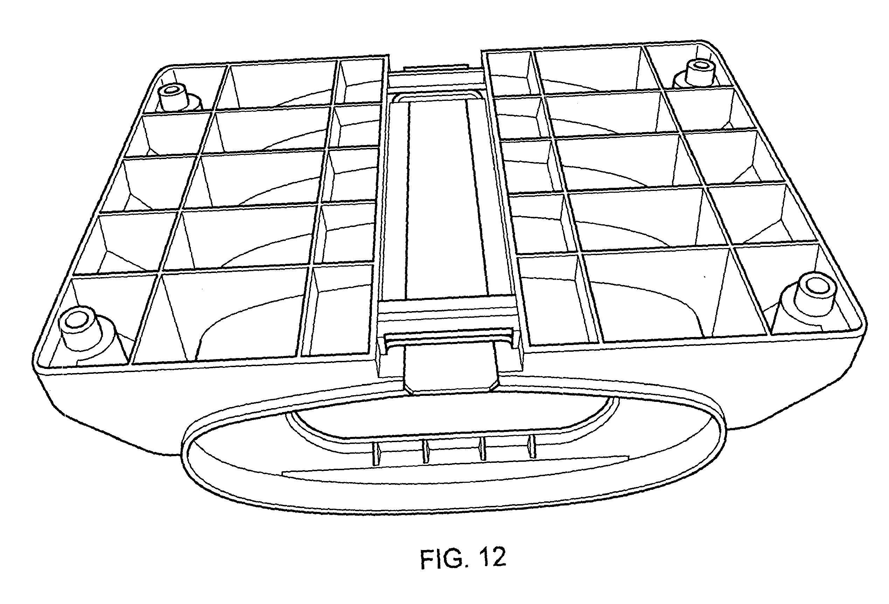

Figure 12 is a perspective view of the underside of the enclosure of Figure 7; and

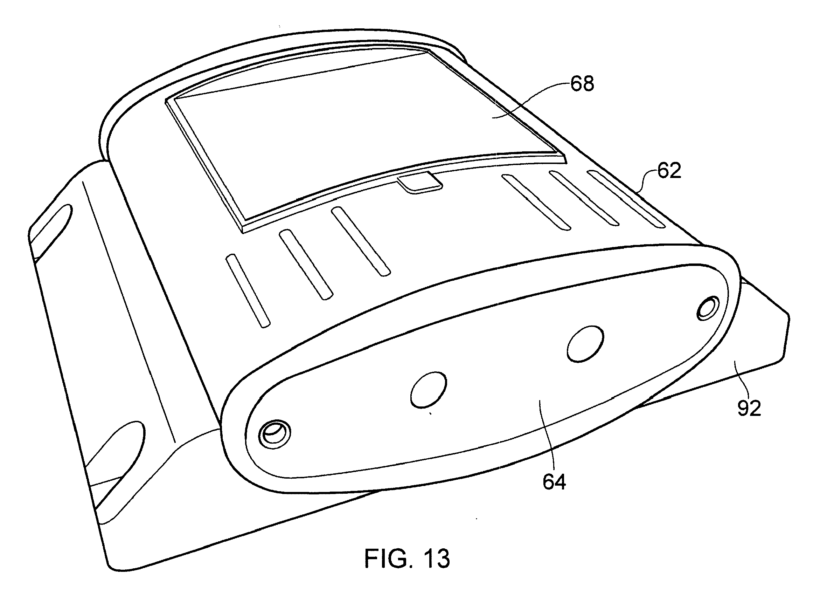

Figure 13 is a perspective of the enclosure of Figure 7 in its assembled condition.

### DESCRIPTION OF THE EMBODIMENTS

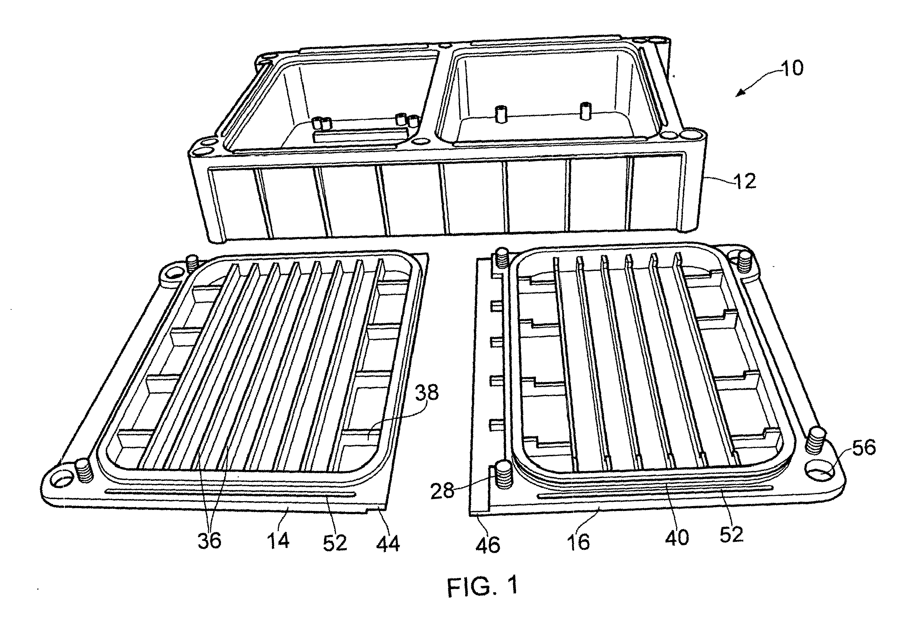

Referring to Figure 1 there is shown a first embodiment of a watertight submersible enclosure 10 for sealingly enclosing electrical/electronic apparatus or the like. In the embodiment of Figure 1 the enclosure comprises three main components including a main body 12, a first closure member 14 and a second closure member 16. The component parts 12, 14 and 16 are preferably of moulded plastics construction, for example, moulded ABS, but the present invention contemplates other plastics and metal enclosures constructed in accordance with the illustrated design.

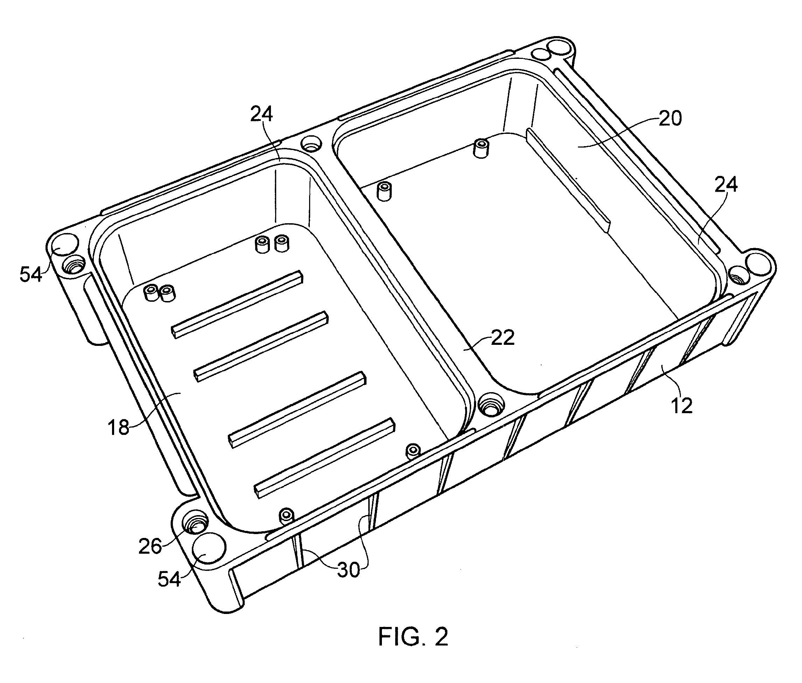

As can best be seen from the illustrated perspective view of Figure 2 the main body part of the enclosure comprises a generally rectangular structure having two adjacent internal compartments 18 and 20 disposed in side by side relation in the hollow interior region of the closure body 12. The internal compartments 18 and 20 are separated by an internal dividing wall 22 which extends perpendicularly from one side of the enclosure body 12 to the other to divide the hollow interior thereof into two open ended compartments 18 and 20 having substantially the same shape and dimensions.

The open end of each of the internal compartments 18 and 20 is provided with a stepped recess 24 extending around its periphery. The stepped recess 24 constitutes one part of a bore seal for sealing the interior region of the compartments 18 and 20 when the respective closure members 14 and 16 are secured to the main body of the enclosure.

A plurality of threaded inserts 26 are distributed around the outer periphery of the enclosure body 12 for receiving threaded fasteners 28 positioned in corresponding apertures around the periphery of the respective closure members 14 and 16. As shown in Figure 2 six such threaded inserts 26 are provided in the enclosure body, one at each corner of the enclosure body and one on each side at a mid point along the length of the enclosure body at a position corresponding to the position of the internal dividing wall 22.

The longitudinal sides of the enclosure body 12 are provided with a plurality of equally spaced strengthening ribs 30 which extend outwards in a plane perpendicular to the longitudinal direction of the enclosure body 12, and which taper from a wide end in the region of the open top of the enclosure body to the base thereof.

In Figure 1 the closure members 14 and 16 are shown with the underside of the respective members face up, the underside being defined as that face that faces the interior of the respective internal compartments 18 and 20 when fitted to the enclosure body to close the open internal compartments.

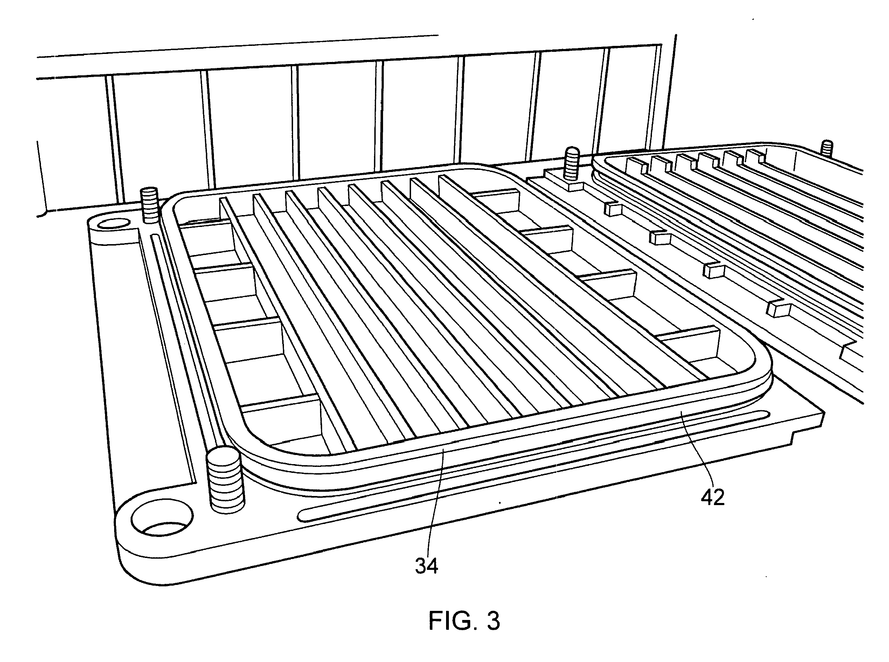

As can be seen in Figure 1, and in more detail in Figure 3, the underside of each closure member 14 and 16 is provided with a plurality of upstanding surface formations, generally indicated 32, surrounded by an upstanding generally rectangular peripheral element 34 which has a shape and size corresponding to the recess 24 so that the upstanding element 34 fits in the recess 24 when the closure element is attached to the open top of the closure to close the respective internal compartment. In this respect it will be understood that the depth of the recess 24 is sufficient to accommodate the depth of the upstanding peripheral element 34 such that the two elements 24 cooperate to form a bore seal when the closure member is attached to the enclosure body as will be described in more detail below.

As previously mentioned the region on the underside of the closure members 14 and 16 bounded by the upstanding element 34 comprises a series of upstanding surface formations 32 in the form of a series of parallel longitudinal ribs 36 and perpendicular formations 38. This can best be seen in the drawing of Figure 1. The ribs 36 and formations 38 on the underside of the closure member 14 are different to those on the underside of the closure member 16, although it will appreciated that the peripheral upstanding element 34 is substantially the same on both. This difference in the shape and configuration of the ribs and formations 38 is a consequence of each internal compartment and its respective closure member being adapted to accommodate different electrical/electronic apparatus and/or power source apparatus such as a battery.

The outward facing side of the peripheral upstanding element 34 is provided with a recess 40 for accommodating a resilient seal element 42 of an elastomeric material, preferably rubber. The seal element 42 protrudes out of the recess 40 so as to sealingly engage the recess 24 in the opening of a respective one of the internal compartment the closure member is associated with.

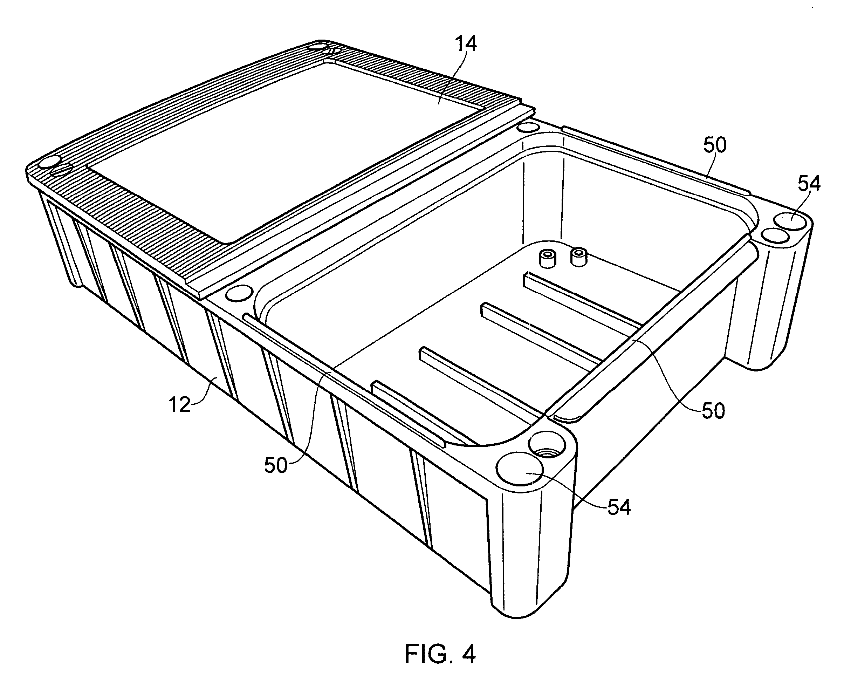

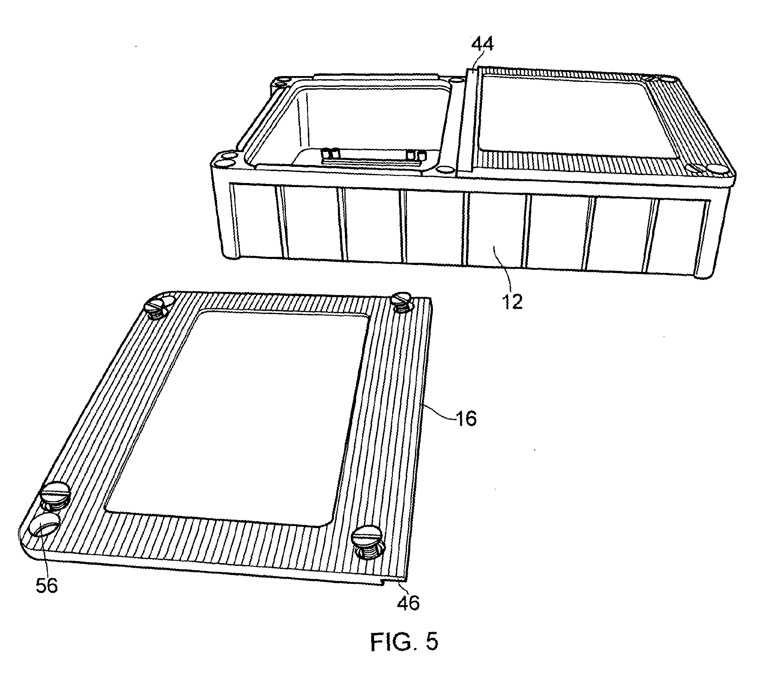

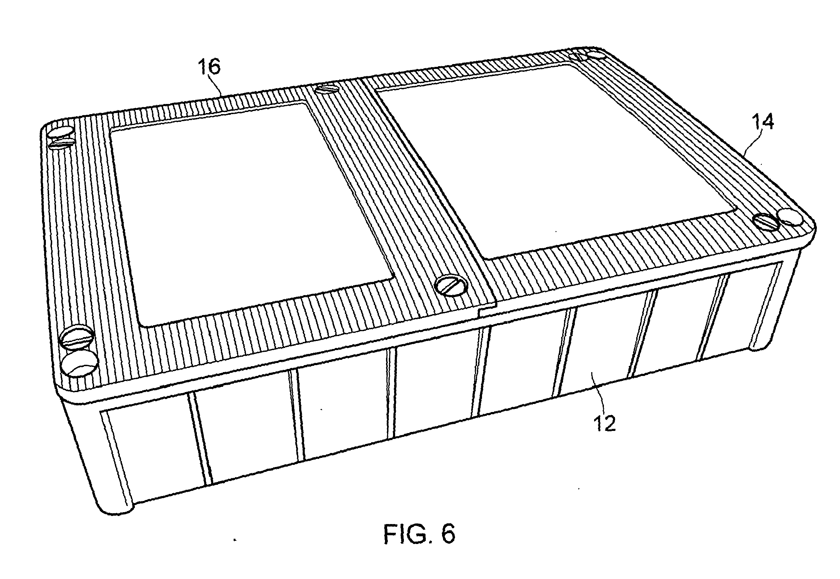

The closure members 14 and 16 are provided with respective overlapping parts in the form of lip elements 44 and 46 which extend along the common adjoining edge of the closure members in such a way that when in the assembled configuration as shown in Figure 6 one of the overlapping parts 44 is clamped by the other 46 against the dividing wall of the enclosure body when the respective closure members 14 and 16 are fixedly secured to the enclosure body to close the respective openings of the respective adjacent internal compartments 18 and 20. This arrangement is illustrated in the sequential views of Figures 4, 5 and 6 where Figure 4 shows the enclosure body 12 with the closure element 14 attached to close the internal compartment 20 with the adjacent compartment 18 open. Figure 5 shows the partly assembled enclosure of Figure 4 with the remaining closure member 16 positioned with its underside face down for attachment to the enclosure body to close the adjacent compartment 18 in such a way that the lip 46 sits on top of the corresponding lip 44 along the adjoining edge of the adjacent closure member. Figure 6 shows the closed enclosure with all six fixing screws 28 securely holding the closure members in clamping engagement with the enclosure body. In this configuration it will be understood that the clamping force provided by the fasteners 28 is sufficient to seal the enclosure against moisture ingress to provide a watertight seal for housing electrical/electronic apparatus and/or a power source, for such apparatus. In this respect it will be understood that one of the internal compartments may be adapted for receiving electrical/electronic apparatus and the other of the internal compartments for housing a battery or other power source with an electrical connection being provided by an appropriate terminal (not shown) in the interior dividing wall 22.

It will be understood that the enclosure may be subject to significant pressure differentials during use due to hydrostatic and/or hydrodynamic pressure acting on the exterior of the enclosure with the interior being sealed at atmospheric pressure. Stiffening of the enclosure is provided by means of elongate upstanding surface formations 50, as best shown in Figure 4, which extend along the edges of the enclosure around the respective openings. The upstanding projections 50 constitute one part of the additional stiffening, the other part being provided by corresponding recessed channels 52 in the underside of the respective closure members 14 and 16.

As shown in Figures 1 to 6 each corner of the enclosure body is provided with a through bore 54, with corresponding through bores 56 in the respective corners of the closure members, for mounting the enclosure to an appropriate supporting structure such as a harbour wall or other maritime structure or vessel.

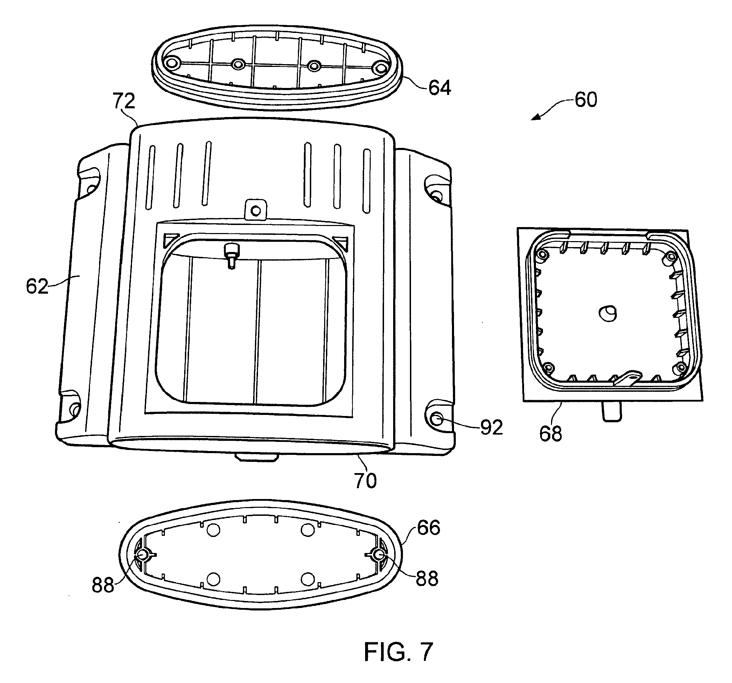

Referring now to Figure 7, there is shown an enclosure 60 according to a second embodiment of the present invention. The enclosure 60 comprises four main components including a main body part 62, a pair of closure members 64 and 66 for closing openings at opposite ends of the closure body 62 and a front cover plate 68 which also constitutes a closure member for closing and opening in the front of the closure member 62 as will be more fully described below. The enclosure 60 includes most of the features present in the first embodiment shown and described with reference to Figures 1 to 6 although the shape and configuration of the enclosure 60 is quite different. The enclosure 60 comprises an opening 70 at one end of the main body 62 and a second opening 72 at the opposite end thereof. The interior of the main body 62 between the respective openings 70 and 72 has a generally ovoid cross section in the plain perpendicular to the longitudinal direction of the enclosure. The closure members 64 and 66 are correspondingly shaped for closing the respective ends of the adjacent internal compartments 74 and 76 in the interior of the main body, which compartments 74 and 76 are divided by means of a dividing wall extending between the adjacent compartments in a plane substantially perpendicular to the longitudinal axis of the main body enclosure part 62. The dividing wall 78 functions in a similar way to the dividing wall 22 in the first embodiment and is provided with electrical terminals 80 for electrically connecting electrical/electronic apparatus in one of the compartments with a battery or other power source located in the other of the compartments. The open ends of the respective internal compartments constitute one part (female element) of a bore seal arrangement for sealingly enclosing the interior of the respective internal compartments when the respective closure members 64 and 66 are attached to the main body 62.

The male part of the bore seal is provided by an upstanding peripheral element 82 on the underside of the respective closure members. In a similar manner to the previously described embodiment the upstanding peripheral element is provided with a recess 84 on its outward facing surface for receiving a seal element 86 in the form of a loop of elastomeric material which is held under slight tension in the groove 84 of the closure members 64 and 66. The dimensions of the recessed groove 84 and the resilient sealing element 86 are such that the sealing element 86 is compressed between the groove 84 and the surface around the periphery of the respective opening to the internal compartment on insertion of the seal element into the respective opening.

The closure members 64 and 66 are fixably secured to the main body 62 by fastening means (not shown) positioned through bore apertures 88 in the closure members so that the closure members may be clamped tightly to the open end of the respective openings.

A similar bore seal arrangement is provided on the underside of the front closure plate 68 so that an effective bore seal is created between the closure plate 68 and a correspondingly shaped recessed region 90 in the front face of the main enclosure body 62.

The enclosure body is further provided with a mounting member 92 for attachment of the enclosure to a support structure. Apertures 92 are provided in scalloped regions at each of the four corners of the mounting member for receiving fixing screws or the like.

## Claims

1. A water tight submersible enclosure for sealingly enclosing electrical/electronic apparatus or the like, said enclosure having at least one opening for access to the interior or a respective internal compartment of the enclosure and at least one respective closure member for closing the said opening, wherein a bore seal is provided at the said opening to seal the said opening against the effects of submersion of the enclosure in water or other liquid when the said respective closure member is attached to close the said opening and wherein at least one location means is provided at the said opening for positively locating the respective closure member on the said opening and the said location means comprises at least one upstanding element on one of the enclosure body or the closure member and a corresponding recess for receiving the said upstanding element on the other.

2. An enclosure as claimed in Claim 1, wherein the said bore seal comprises a pair of mating elements, one on the said closure member and one around the periphery of the opening such that the said elements are brought together when the closure member is attached to close the said opening.

3. An enclosure as claimed in Claim 2, wherein the mating elements comprise a female element and a male element, the bore seal further comprising a resilient seal element positioned between the male and female elements.

4. An enclosure as claimed in Claim 3, wherein the said female element is provided by or in the opening and the said male element comprises an upstanding protrusion on the said closure member adapted to fit in the opening.

5. An enclosure as claimed in Claim 4, wherein the male element includes a recess in the said upstanding protrusion for accommodating the said resilient seal element.

6. An enclosure as claimed in any of Claims 3 to 5, wherein the said female element comprises a stepped recess at the said opening.

7. An enclosure as claimed in any of Claims 3 to 6, wherein the said resilient seal element comprises an elastomeric material.

8. An enclosure as claimed in any preceding claim, wherein the interior of the enclosure is divided to provide at least two internal compartments each having a respective opening and closure member.

9. An enclosure as claimed in Claim 8, wherein adjacent closure members are provided with respective overlapping parts extending along a common adjoining edge such that one of the overlapping parts is clamped by the other against the body of the enclosure when the said closure members are fixedly secured to the enclosure to close the respective openings of respective adjacent internal compartments.

10. An enclosure as claimed in Claim 8 or Claim 9, wherein one of said internal compartments is adapted to accommodate electrical/electronic apparatus and another of said compartments is adapted to accommodate a power source such as battery or the like for providing power to the said electrical/electronic apparatus.

11. An enclosure as claimed in any preceding claim, wherein electrical terminal means are provided in a dividing wall between respective adjacent compartments for electrically connecting electrical/electronic apparatus and/or electrical power source means accommodated in adjacent compartments.

12. An enclosure as claimed in any preceding claim, wherein fixing means are provided for securely fixing the said closure member to the body of enclosure to close the said respective opening.

13. An enclosure as claimed in any preceding claim, comprising a pair of adjacent internal compartments and wherein the said respective openings are arranged in side by side relation on one side of the enclosure or are arranged at respective opposite ends of the enclosure.
